Europäisches Patentamt

European Patent Office

Office européen des brevets

(19)

(11) Veröffentlichungsnummer: **0 005 185**
**B1**

# (12) EUROPÄISCHE PATENTSCHRIFT

(45) Veröffentlichungstag der Patentschrift:
14.10.81

(21) Anmeldenummer: **79101076.2**

(22) Anmeldetag: **09.04.79**

(51) Int. Cl.³: **H 01 L 21/60,** H 01 L 23/48,
H 01 L 21/285, H 01 L 29/48

(54) Verfahren zum gleichzeitigen Herstellen von Schottky-Sperrschichtdioden und ohmschen Kontakten nach dotierten Halbleiterzonen.

(30) Priorität: **01.05.78 US 901902**

(43) Veröffentlichungstag der Anmeldung:
**14.11.79 Patentblatt 79/23**

(45) Bekanntmachung des Hinweises auf die Patenterteilung:
**14.10.81 Patentblatt 81/41**

(84) Benannte Vertragsstaaten:
**DE FR GB**

(56) Entgegenhaltungen:
**CH-A-479 163**
**DE-A-1 764 248**
**DE-A-1 959 895**
**US-A-3 900 944**
**US-A-3 906 540**
**US-A-3 956 527**
**IBM TECHNICAL DISCLOSURE BULLETIN
Band 20, Mai 1978
NEW YORK (US)
W. CHU et al.: »Low barrier height
ohmic contact to semiconductor
substrates«, Seite 5168**

(73) Patentinhaber: **International Business Machines
Corporation, Armonk, N.Y. 10504 (US)**

(72) Erfinder: **Friedman, Jules David, Steiner Dr. RFD No. 1,
Mahopac NY 10541 (US)**
Erfinder: **Saraf, Lumdas Hiraman, 2 York Court, Fishkill
NY 12524 (US)**

(74) Vertreter: **Böhmer, Hans Erich, Dipl.-Ing., Schönaicher
Strasse 220, D-7030 Böblingen (DE)**

**IMB TECHNICAL DISCLOSURE BULLETIN
Band 21, Juni 1978
NEW-YORK (US)
J. J. GNIEWEK et al.: »Forming
high and low barrier height
Schottky diodes and ohmic contacts
with VPt-Si«, Seite 146
IBM TECHNICAL DISCLOSURE BULLETIN
Band 21, August 1978
NEW-YORK (US)
R. LEVI et al.: »Low. Barrier
integrated Schottky clamp fabrication«,
Seiten 1058 – 1061**

## Verfahren zum gleichzeitigen Herstellen von Schottky-Sperrschichtdioden und ohmschen Kontakten nach dotierten Halbleiterzonen

Die Erfindung betrifft ein Verfahren zum gleichzeitigen Herstellen von Schottky-Sperrschichtkontakten und ohmschen Kontakten nach dotierten Halbleiterzonen, bei welchem in eine erste Gruppe darstellenden und über N+-leitenden sowie N-leitenden oder P-leitenden Siliciumbereichen liegenden Öffnungen in einer aus dielektrischen Materialien bestehenden Maskenschicht zur Herstellung der ohmschen Kontakte und von Schottky-Sperrschichtkontakten mit hoher Potentialschwelle durch eine diese Öffnungen freigebende Photolackmaske hindurch eine Metallschicht niedergeschlagen und zu einem Metallsilicid gesintert wird. Ein derartiges Verfahren ist aus der US-A-3 956 527 bekannt.

Die technische Weiterentwicklung von mikrominiaturisierten, integrierten Halbleiterschaltungen hat solche verbesserte Verfahren zum Herstellen leitender Kontakte an die mit Störstellen dotierten Zonen des Halbleiters erforderlich gemacht. Dies wurde durch neuartige, hochentwickelte lithographische Verfahren, verbesserte Verfahren zum Niederschlag von Materialien und Metallisierungen erreicht. Insbesondere wurden neue Kombinationen von Metallen entwickelt, die die Herstellung von ohmschen und von Schottky-Sperrschichtkontakten an die mit Störstoffen dotierten Zonen ermöglichen. Allgemein gesagt, erfordern hochentwickelte, integrierte Halbleiterschaltungen drei Arten von Kontakten, die an mit Störstoffen dotierte Zonen herzustellen sind:

Ohmsche Kontakte, Schottky-Sperrschichtkontakte mit niedriger Potentialschwelle (LSB) und Schottky-Sperrschichtkontakte mit hoher Potentialschwelle (HSB). Wie in der genannten US-A-3 995 301 und der Europäischen Patentanmeldung 78 100 525 (EU-A-0 000 743) angedeutet, hat es bei der Auswahl der richtigen Metallisierungssysteme, die zufriedenstellende Kontakte in bezug auf Schaltgeschwindigkeit, Kontaktwiderstand und Spannungsabfälle liefern, Schwierigkeiten gegeben.

Aus der US-A-3 906 540 ist die Herstellung von Schottky-Sperrschichtdioden in der Weise bekannt, daß auf der freigelegten Oberfläche eines aus Silicium bestehenden Substrats z. B. Platin niedergeschlagen wird, das dann zu Platinsilicid gesintert wird. Über der PtSi-Schicht wird dann eine Sperrschicht aus Mo, W, Ta oder Ti niedergeschlagen, die eine Wechselwirkung zwischen einer noch aufzubringenden Metallisierung aus Aluminium und dem Platinsilicid verhindern soll.

Aus der DE-A-1 959 895 ist ein Verfahren zum selektiven Dotieren der Gate-, Source- und Drainzone eines Feldeffekttransistors bekannt. Dort ist auch angegeben, daß ebenso selktiv durch Niederschlagen von PtSi auf der Oberfläche eines Siliciumsubstrats eine Schottky-Diode hergestellt werden kann.

Weitere Schwierigkeiten sind bei der Herstellung von Kontakten während der Entwicklung eines optimalen Verfahrens für selektiven Niederschlag einer bestimmten Art von Kontakten in einer oder mehreren gleichartigen Zonen auf dem Halbleitersubstrat und beim Niederschlagen anderer Arten von Kontakten in anderen Zonen aufgetreten.

Eine weithin verwendete Metallisierung, die sich sowohl für ohmsche Kontakte als auch für Schottky-Sperrschichtkontakte eignet, ist eine Schicht eines metallischen Silicids, beispielsweise Platinsilicid, das in unmittelbarer Berührung mit dem Siliciumsubstrat steht. Der Grund dafür ist darin zu sehen, daß eine Kontaktierung von Silicium durch Aluminium weniger zufriedenstellend ist. Über dem Platinsilicid kann eine Reihe von Metallen niedergeschlagen werden, wie zum Beispiel Aluminium, Chrom, Gold usw. Wenn Platinsilicid auf einer mit Störstoffen dotierten Zone mit einer relativ geringen Dotierung niedergeschlagen wird, dann bildet sich dabei eine Schottky-Sperrschichtdiode, während die Bildung einer Platinsilicid-Schicht auf einem Substrat mit hoher Störelementkonzentration einen ohmschen Kontakt liefert.

Wie bereits aus der US-Patentschrift 3 995 301 bekannt ist, haben Platinsilicid-Schottky-Sperrschichtkontakte eine relativ hohe Potentialschwelle in Durchlaßrichtung von etwa 0,8 Volt. Daraus ergab sich die Notwendigkeit für die Entwicklung weiterer metallischer Kontaktsysteme zur Bildung von Schottky-Sperrschichtkontakten mit niedriger Potentialschwelle in Durchlaßrichtung.

Ein brauchbares metallurgisches System, das in der Europäischen Patentanmeldung der Anmelderin mit dem Aktenzeichen 78 100 525 (EU-A-0 000 743) beschrieben ist, offenbart die Herstellung einer Schottky-Sperrschichtdiode mit niedriger Potentialschwelle durch den Niederschlag von Tantal unter sorgfältig gesteuerten Bedingungen auf einer N-leitend dotierten Zone eines Silicium-Halbleitersubstrats. Eine Schottky-Sperrschichtdiode mit hoher Potentialschwelle in Durchlaßrichtung und die ohmschen Kontakte werden zuerst dadurch hergestellt, daß Platinsilicid in anderen N-dotierten bzw. N+-dotierten Zonen niedergeschlagen wird. Daraufhin wird über dem Platinsilicid Tantal niedergeschlagen.

Bei dem Verfahren zum Niederschlagen dieser getrennten Metallisierungsschichten zur Bildung unterschiedlicher Arten von Halbleiterkontakten wird Platin in den auf dem Substrat vorgesehenen Öffnungen niedergeschlagen, in denen ohmsche und Schottky-Sperrschichtkontakte mit hoher Potentialschwelle gebildet werden sollen. Die Öffnungen, in denen Schottky-Sperrschichtkontakte mit niedriger Potentialschwelle gebildet werden sollen, sind zu diesem Zeitpunkt durch eine beispielsweise aus Siliciumdioxid bestehende Diffusionsmaske geschützt. Nach Niederschlagen der Platinschicht und einer Sinterung zur Bildung von Platinsilicid wird das gesamte Substrat mit Ausnahme der Kontaktöffnungen für die LSB-Kontakte vorzugsweise durch eine Photolackmaske abgedeckt. Die Diffusionsmaske wird dann am Ort der LSB-Kontaktöffnungen abgeätzt. Anschließend wird die Photolackmaske entfernt. Dadurch werden alle Öffnungen auf dem Substrat freigelegt, so daß anschließend Tantal in all den Öffnungen niedergeschlagen werden kann.

Dieses Verfahren, obwohl sich dadurch zufriedenstellende Kontakte herstellen lassen, ist nicht so zuverlässig, wie dies gewünscht wird. Zunächst erfordert der Niederschlag eines gesonderten Metallisierungssystems einen zusätzlichen Verfahrensschritt zum Aufbringen einer Photolackmaske. Außerdem wird die Photolackschicht unmittelbar auf den Platinsilicid-Schichten niedergeschlagen. Bei den üblichen Verfahren des Aufbringens, Freilegens und Entwickelns einer Photolackschicht muß diese zum Austreiben der Lösungsmittel des Photolacks einer Wärmebehandlung unterzogen werden. Daraus ergibt sich eine zähe Schicht, die dazu neigt, fest an der Platinsilicid-Schicht zu haften. Das Entfernen des Photolacks ist also recht schwierig, und es wurde festgestellt, daß dabei unerwünschte Verunreinigungen auf der Oberseite der Platinsilicid-Schicht verbleiben.

Aufgabe der Erfindung ist es, ein Verfahren zur selektiven Herstellung unterschiedlicher Arten von Kontakten an Halbleitersubstraten zu schaffen, die unterschiedliche Kombinationen von leitenden Schichten erfordern, ohne daß dazu wie bisher so viele Verfahrensschritte erforderlich sind, während gleichzeitig die sonst bei Photolackverfahren bei der Bildung von Halbleiterkontakten auftretenden Verunreinigungen verringert werden. Diese der Erfindung zugrundeliegende Aufgabenstellung wird dadurch gelöst, daß eine zweite Gruppe darstellende und über N-leitenden Siliciumbereichen liegende Öffnungen gleichzeitig mit der ersten Gruppe von Öffnungen in der Maskenschicht hergestellt und vor dem Abscheiden der Metallschicht mit einer abschirmenden Schicht verschlossen wird, daß nach dem Erzeugen des Metallsilicids die abschirmende Schicht aus den Öffnungen der zweiten Gruppe entfernt wird und daß auf das Metallsilicid in den Öffnungen der ersten Gruppe und gleichzeitig zur Herstellung von Schottky-Sperrschichtkontakten mit niedriger Potentialschwelle auf die Substratoberfläche in den Öffnungen der zweiten Gruppe eine Tantalschicht niedergeschlagen wird. Vorzugsweise wird als Material für die Metallschicht Platin verwendet.

Dabei wird eine Diffusionsmaske zur Festlegung aller Kontaktbereiche verwendet. Als abschirmende Schicht wird Oxid in jedem der Kontaktbereiche entweder thermisch aufgewachsen oder chemisch aus der Dampfphase niedergeschlagen. Anschließend wird eine sperrende Photolackschicht aufgebracht und in ein solches Muster umgeformt, das die abschirmenden Oxidschichten über denjenigen Bereichen freilegt, in denen die erste Gruppe von Kontakten gebildet werden soll. Die erste Metallisierungsschicht, typischerweise Platinsilicid, wird dann gebildet. Dann wird die abschirmende Oxidschicht von den darunterliegenden geschützten Kontaktbereichen entfernt, und eine Tantalschicht wird in allen Kontaktöffnungen niedergeschlagen. Dadurch erhält man in der zweiten Gruppe von Kontaktöffnungen eine Tantalschicht und in der ersten Gruppe zwei Metallisierungsschichten.

In diesem Fall stellen die nur mit einer Tantalschicht überzogenen Kontaktbereiche Schottky-Sperrschichtdioden mit niedriger Potentialschwelle dar, während die zwei Metallisierungsschichten aufweisenden Kontaktöffnungen entweder ohmsche Kontakte oder Schottky-Sperrschichtkontakte mit hoher Potentialschwelle darstellen.

Das neuartige Verfahren läßt sich auch auf Systeme erweitern, bei denen mehr als zwei Metallisierungsschichten erforderlich sind, beispielsweise dann, wenn getrennte Metallisierungsebenen nötig sind.

Die Erfindung wird nunmehr an Hand von Ausführungsbeispielen in Verbindung mit den beigefügten Zeichnungen im einzelnen beschrieben.

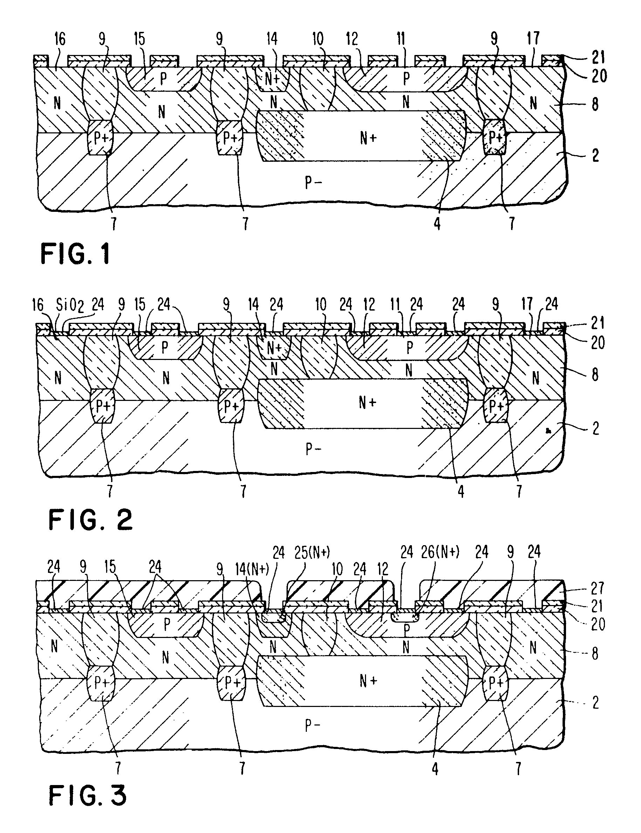

Fig. 1 bis 6 zeigen Teilschnittansichten einer erfindungsgemäß hergestellten Halbleitervorrichtung während der verschiedenen Verarbeitungsstufen.

### Einzelbeschreibung
### der bevorzugten Ausführungsform

Für den Verlauf der Beschreibung soll der Ausdruck Schicht ein Material oder Materialien bedeuten, die ohne Änderung in den Masken niedergeschlagen werden können. Somit kann eine leitende Schicht oder ein dünner Film mehr als ein Material enthalten. Beispielsweise kann eine Schicht aus einem oder mehreren Metallen, wie z. B. Aluminium-Chrom, Chrom-Tantal, Aluminium-Chrom-Tantal usw. zusammengesetzt sein.

Fig. 1 zeigt eine zum Teil fertiggestellte integrierte Schaltung mit einer oberhalb eines P-leitenden Substrats 2 liegenden epitaxial aufgewachsenen N-leitenden Schicht 8. Eine Subkollektorzone 4 und eine P+-leitende Isolationszone 7 sind in die epitaxiale Schicht 8 ausdiffundiert. Vorzugsweise weist die Schicht 8 eine Dicke von etwa 2 μm oder weniger auf und besitzt eine Störelementkonzentration von 2,1 bis $2,3 \times 10^{16}$ Atomen je cm³. Das Substrat hat beispielsweise einen spezifischen Widerstand von 10 Ohm cm. Die Zonen 4 und 7 werden vorteilhafterweise durch Eindiffundieren in Öffnungen einer Maskenschicht hergestellt, die diese Abschnitte des Substrats 2 freilegen. N+-Leitung hervorrufende Störelemente sind Arsen und Phosphor, und ein typisches, eine P+-Leitfähigkeit hervorrufendes Störelement ist Bor.

Die Maskenschicht wird dann von dem Substrat durch übliche Ätzverfahren abgezogen, und die Schicht 8 wird epitaxial aufgewachsen, wodurch die Zonen 4 und 7 in die opitaxial aufgewachsene Schicht ausdiffundieren.

Die Epitaxialschicht 8 enthält außerdem versenkt angeordnete Isolierzonen 9 und 10, die die verschiedenen Bereiche der innerhalb der Schicht 8 zu bildenden Bauelemente gegeneinander isolieren. Zu diesen Bauelementen gehört ein P-leitender Widerstand 15, eine N+-leitende, nach dem Subkollektor durchreichende Zone 14 und eine P-leitende Basiszone 12. Eine weitere Isolierzone 10 trennt die Zone 14 von der Basiszone 12.

Die Isolierzonen 9 und 10 werden durch Einätzen von Vertiefungen in die Epitaxialschicht 8 gebildet. Eine dafür geeignete Maske, die beispielsweise aus Siliciumdioxid und Siliciumnitrid zusammengesetzt sein kann, deckt die übrigen Teile des Substrats ab, in denen keine Vertiefungen gebildet werden sollen. Diese Vertiefungen werden dann entweder durch nasse Ätzverfahren oder durch reaktives Ionenätzen hergestellt. Diese Vertiefungen werden dann mit Siliciumdioxid in der Weise ausgefüllt, daß man trockenen Sauerstoff oder eine Kombination von Wasserdampf und Sauerstoff oder beides einsetzt. Andererseits könnte Siliciumdioxid auch statt durch thermische Verfahren unmittelbar in den Vertiefungen niedergeschlagen werden. Die N+-leitende Zone 14 wird dann durch Maskenverfahren hergestellt, worauf dann die Widerstandszone 15 und die Basiszone 12 gebildet werden.

Bis jetzt wurde ein dem Fachmann wohlbekannter Aufbau einer Halbleiterschaltung beschrieben. Dem Fachmann sind außerdem weitere Verfahren zum Herstellen der verschiedenen, mit Störelementen dotierten Zonen innerhalb des Halbleitersubstrats geläufig. Die Basiszone 11 und die Widerstandszone 15 könnten beispielsweise entweder durch Diffusion oder durch Ionenimplantationsverfahren hergestellt werden. Andere Verfahren zum Bilden von Isolationszonen sind ebenfalls bekannt. Das in der Europäischen Patentanmeldung 78 101 787 (EU-A-0 002 797) offenbarte Verfahren zum Herstellen der Basiszone 11 und der Widerstandszone 15 ist ebenfalls sehr vorteilhaft. Diese zuvor genannten Verfahrensschritte sollen lediglich das beste derzeit bekannte Verfahren zur Durchführung der Erfindung darlegen. Die in Fig. 1 gezeigte Struktur und das dabei zur Herstellung dieses Halbleiteraufbaus benutzte Verfahren sind nicht Teil der vorliegenden Erfindung.

Das neue Verfahren wird nunmehr mit der Bildung einer Diffusionsmaske aus einer thermisch aufgewachsenen Oxidschicht 20 und einer chemisch aus der Dampfphase niedergeschlagenen Siliciumnitrid-Schicht 21 fortgesetzt. In dieser zusammengesetzten Maskenschicht sind entsprechende Öffnungen hergestellt, in denen leitende Kontaktanschlüsse an verschiedene ausgewählte Zonen innerhalb der epitaxialen Schicht 8 hergestellt werden sollen.

Eine Öffnung wird über der Zone 17 hergestellt, in der eine Schottky-Sperrschichtdiode mit einer Potentialschwelle in Durchlaßrichtung von etwa 0,8 Volt gebildet werden soll. Eine weitere Öffnung wird oberhalb der Basiszone 12 für die Bildung einer Emitterzone hergestellt. Auf jeder Seite der Emitterzone 11 ist je eine Öffnung zur Herstellung eines ohmschen Kontakts an die Basiszone vorgesehen. Ferner sind Öffnungen für die nach der N+-leitenden Zone 14 und nach der P-leitenden Widerstandszone 15 führenden ohmschen Kontakte vorgesehen.

Die letzte Öffnung in diesem Teilabschnitt der Halbleiterschaltung befindet sich über der Zone 16, in der eine LSB-Diode mit einer Potentialschwelle in Durchlaßrichtung von etwa 0,5 Volt gebildet werden soll. Es ist dem Fachmann natürlich klar, daß auf demselben Halbleiterplättchen normalerweise viele Tausende von Dioden und anderen Halbleiterbauelementen, wie z. B. Transistoren, Widerständen und dergleichen angeordnet sind. Ferner ist es ohne weiteres einleuchtend, daß nicht alle in der Zeichnung dargestellten Zonen für eine ausführliche Darstellung der Erfindung erforderlich sind. Diese Darstellung soll nur die bestmögliche Art zur Durchführung der Erfindung erläutern.

Gemäß Fig. 2 wird nunmehr eine abschirmende Oxidschicht 24 in jeder der zuvor beschriebenen Öffnungen in der zusammengesetzten Maskenschicht 20, 21 niedergeschlagen. Die abschirmende Oxidschicht 24 wird vorzugsweise in trockenem Sauerstoff bei 1000° C für etwa 30 Minuten bis zu einer Dicke von 25 Nanometern thermisch aufgewachsen. Es wurde festgestellt, daß diese Schichtdicke für einen Schutz gegen eine Verunreinigung während der nachfolgenden Verfahrensschritte ausreicht, jedoch ausreichend dünn ist, so daß sie leicht durch Tauchätzen entfernt werden kann. Statt dem thermischen Aufwachsen der Oxidschicht kann diese auch in üblicher Weise durch chemischen Niederschlag aus der Dampfphase aufgebracht werden. Beispielsweise kann eine Siliciumdioxid-Schicht pyrolitisch in einer Kammer niedergeschlagen werden, die Silan, Kohlendixod und Wasserstoff bei einer Temperatur von etwa 1000° C enthält, wobei die Behandlungsdauer etwa 2 Minuten beträgt. Entsprechend Fig. 3 wird dann durch übliche lithographische Verfahren eine Photolackmaske 27 erzeugt, mit der in dem Substrat nur die Emitterzone und die nach dem Subkollektor 4 führende Zone 14 zugänglich ist. Ganz allgemein gesagt, soll die als Sperrmaske dienende Photolackmaske 27 alle N-leitenden Zonen in dem Substrat zugänglich machen. Zu diesem Zeitpunkt wird eine N+-leitende Emitterzone 26 und eine noch stärker N+-leitende Zone 25 in der Zone 14 gebildet, vorzugsweise durch Ionenimplantation von Ar-

sen oder Phosphor durch die abschirmende Oxidschicht 24 hindurch.

Andererseits kann die Bildung der Zonen 25 und 26 auch durchgeführt werden, nachdem die Oxidschicht 24 in den freiliegenden Bereichen, vorzugsweise durch Verwendung von gepufferter Flußsäure abgeätzt ist. Diese Zonen würden dann entweder durch Ionenimplantation direkt in das Substrat eingeführt oder durch übliche Diffusionsverfahren hergestellt. Nach Herstellung der Zonen 25 und 26 wird die sperrende Photolackmaske durch Verbrennung oder Veraschung in einer Plasmaätzkammer mit Sauerstoff oder durch ein nasses Ablöseverfahren entfernt.

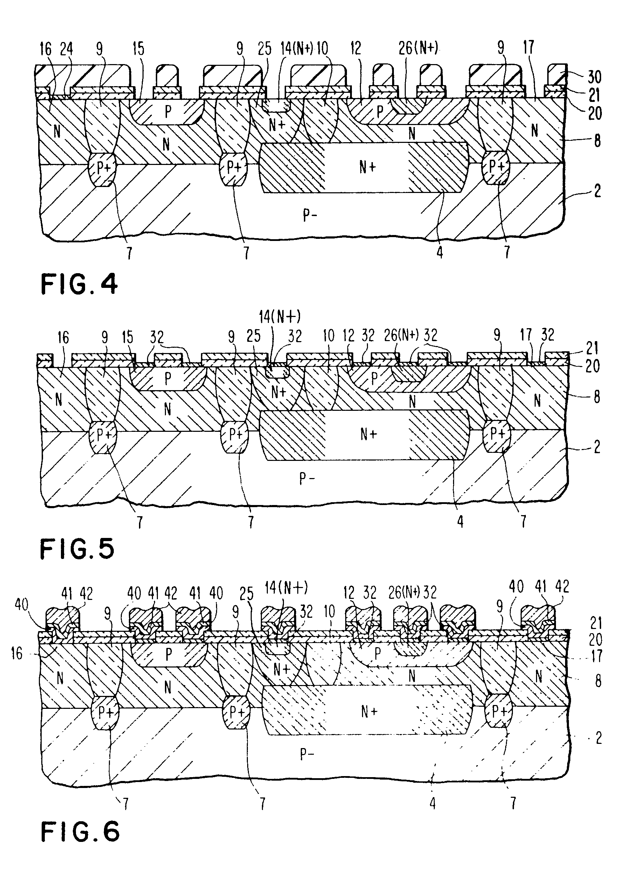

Nach Eintreiben der Emitterzone 26 und der noch stärker dotierten Zone 25 wird eine weitere sperrende Maske 30 niedergeschlagen, belichtet und entwickelt und legt damit alle mit Störstoffen dotierten Zonen innerhalb des Substrats mit Ausnahme der in Fig. 4 gezeigten Zone 16 frei. Die Zone 16 wird dabei für den LSB-Diodenkontakt freigehalten, der in einem späteren Verfahrensschritt gebildet werden soll. Das Freilegen dieser Teile erfordert das Ablösen oder Entfernen der abschirmenden Oxidschicht 24 aus jeder der Öffnungen nach der Entwicklung der schützenden Photolackschicht 30. Somit kommt die Photolackschicht 30 niemals in Berührung mit einer der Zonen innerhalb der epitaxialen Schicht mit Ausnahme der abschirmenden Oxidschicht 24.

Die Oxidschicht 24 wird dann durch Tauchätzen des gesamten Substrats in gepufferter Flußsäure entfernt, einem Ätzmittel, das die Photolackschicht 30 nicht wesentlich angreift. Trockenätzverfahren können ebenfalls benutzt werden. Die über der Zone 16 liegende Oxidschicht 24 ist jedoch gegen das Ätzmittel durch die Photolackschicht 30 geschützt.

Die Photolackschicht 30 wird dann abgezogen, vorzugsweise durch das oben in Verbindung mit der Photolackschicht 27 erwähnte Verfahren. Damit sind alle mit Störstoffen dotierten Zonen mit Ausnahme der Zone 16 freigelegt, die immer noch durch die abschirmende Oxidschicht 24 geschützt ist.

Anschließend wird gemäß Fig. 5, alles überdeckend, über der Schicht 21 und innerhalb aller Öffnungen mit Ausnahme der Öffnung 16, die durch die abschirmende Oxidschicht 24 immer noch geschützt ist, eine Platinschicht 32 niedergeschlagen. Vorzugsweise wird die Platinschicht bis zu einer Dicke von etwa 40 Nanometern durch Verdampfung oder Zerstäubung niedergeschlagen. Die Halbleiterscheibe wird dann für etwa 20 Minuten bei 550°C in einer Stickstoffatmosphäre gesintert, wodurch das Platin mit dem Silicium zur Bildung von Platinsilicid reagiert. Das nicht umgesetzte Platin, das beispielsweise über der Nitridschicht 21 liegt, wird dann durch Ätzen beispielsweise mit Königswasser entfernt. Dem Fachmann ist bekannt, daß andere Metalle, wie z. B. Palladium, Nickel oder Hafnium an Stelle von Platin verwendet werden können.

Beim nächsten Verfahrensschritt wird der Teil der abschirmenden Oxidschicht 24, der über der Zone 16 liegt, vorzugsweise durch Tauchätzen zum Freilegen der LSB-Diodenzone 16 abgeätzt. Dabei müssen die Platinsilicid-Kontakte 32 nicht geschützt werden, da sie durch gepufferte Flußsäure nicht beeinträchtigt werden.

Die übrige Metallisierung wird dann in allen Öffnungen in der zusammengesetzten Maskenschicht 20, 21 niedergeschlagen, wie dies Fig. 6 zeigt. Das bevorzugte Verfahren enthält ein Ablöseverfahren, wie es beispielsweise in der US-Patentschrift 4 004 044 offenbart ist. Dieses Verfahren ist ebenfalls in der obengenannten Europäischen Patentanmeldung 78 100 525 (EU-A-0 000 743) beschrieben und soll hier nicht wiederholt werden. Andere Verfahren zur Bildung einer Metallisierung sind beispielsweise übliche Naßverfahren oder subtraktive reaktive Ionen- oder Plasma-Ätzverfahren, die dem Fachmann geläufig sind. Die Abziehverfahren liefern jedoch eine genauere Abgrenzung der Metallisierung und halten damit die für die Verdrahtung erforderliche Fläche sehr klein.

Die Zone 17 ist ein HSB-Diodenkontakt. Die Zone 16 ist ein LSB-Diodenkontakt, und die anderen Zonen, über denen eine Metallisierung niedergeschlagen ist, sind ohmsche Kontakte. Vorzugsweise besteht die Metallisierung, wie das die obengenannte Europäische Patentanmeldung 78 100 525 (EU-A-0 000 743) darlegt, aus Tantal 40, Chrom 41 und Aluminium 42. Der Ausdruck Aluminium soll dabei auch mit Kupfer dotiertes Aluminium und mit Kupfer dotiertes Aluminiumsilicium umfassen. Obgleich dies derzeit das beste bekannte Metallisierungssystem ist, soll durch die Erfindung die Verwendung anderer metallurgischer Systeme nicht ausgeschlossen werden.

Es wird angenommen, daß der wesentliche Vorteil der Erfindung darin zu sehen ist, daß zu keinem Zeitpunkt eine ausgehärtete Photolackschicht über den Platinsilicid-Kontakten 32 liegt. Damit wird die Schwierigkeit umgangen, die beim Ablösen einer zähen Photolackschicht über Platin auftretenden Verunreinigungen entfernen zu müssen.

Außerdem kann die über der LSB-Diodenzone 16 liegende Oxidschicht 24 durch Tauchätzen entfernt werden, so daß keine weitere Maskenschicht zum Schutz der anderen Öffnungen in dem Substrat erforderlich ist, die jeweils Platinsilicid enthalten, wenn die Oxidschicht 24 entfernt wird (Fig. 4). Dadurch wird im Vergleich mit üblichen Metallisierungsverfahren ein Maskenschritt überflüssig.

**Patentansprüche**

1. Verfahren zum gleichzeitigen Herstellen von Schottky-Sperrschichtkontakten und ohmschen Kontakten nach dotierten Halbleiterzonen, bei welchem in eine erste Gruppe darstellenden und über N⁺-leitenden (14; 25, 26) sowie N-leitenden oder P-leitenden Siliciumbereichen (12, 15, 17) liegenden Öffnungen in einer aus dielektrischen Materialien bestehenden Maskenschicht zur Herstellung der ohmschen Kontakte und von Schottky-Sperrschichtkontakten mit hoher Potentialschwelle durch eine diese Öffnungen freigebende Photolackmaske (30) hindurch eine Metallschicht (32) niedergeschlagen und zu einem Metallsilicid gesintert wird, dadurch gekennzeichnet,

daß eine zweite Gruppe darstellende und über N-leitenden Siliciumbereichen (16) liegende Öffnungen gleichzeitig mit der ersten Gruppe von Öffnungen in der Maskenschicht (20, 21) hergestellt und vor dem Abscheiden der Metallschicht (32) mit einer abschirmenden Schicht (24) verschlossen wird,

daß nach dem Erzeugen des Metallsilicids die abschirmende Schicht (24) aus den Öffnungen der zweiten Gruppe entfernt wird und

daß auf das Metallsilicid in den Öffnungen der ersten Gruppe und gleichzeitig zur Herstellung von Schottky-Sperrschichtkontakten mit niedriger Potentialschwelle (LSB) auf die Substratoberfläche in den Öffnungen der zweiten Gruppe eine Tantalschicht (40) niedergeschlagen wird.

2. Verfahren nach Anspruch 1, dadurch gekennzeichnet, daß als Material für die Metallschicht Platin verwendet wird.

## Claims

1. Method for simultaneously forming Schottky barrier contacts and ohmic contacts to doped semiconductor zones, wherein in openings representing a first group and disposed atop N⁺ conductive (14; 25, 26) as well as N conductive or P conductive silicon regions (12, 15, 17) in a mask layer consisting of dielectric materials for forming the ohmic contacts and Schottky barrier contacts with a high potential threshold, a metal layer (32) is deposited through a photoresist mask (30) not covering said openings and is sintered to form a metal silicide, characterized in that openings representing a second group and disposed atop N conductive silicon regions (16) are produced simultaneously with the first group of openings in the mask layer (20, 21) and are sealed prior to deposition of the metal layer (32) by means of a screening layer (24),

that after the metal silicide has been generated, the screening layer (24) is removed from the openings of the second group, and that a tantalum layer (40) is simultaneously deposited on the metal silicide in the openings of the first group and, for producing Schottky barrier contacts with a low potential threshold (LSB), on the substrate surface in the openings of the second group.

2. Method in accordance with claim 1, characterized in that platinum is used as a material for the metal layer.

## Revendications

1. Procédé pour fabriquer simultanément des contacts à barrière de Schottky et des contacts ohmiques avec des régions semi-conductrices dopées du genre comprenant le dépôt d'une couche métallique (32) et son frittage pour obtenir un siliciure de métal, dans un premier groupe d'ouvertures situées au-dessus des régions de silicium de conductivité N⁺ (14; 25, 26) et des régions de silicium de conductivité N ou P (12, 15, 17); lesdites ouvertures sont formées dans une couche de masquage composée de matériaux diélectriques à travers un masque photorésistant exposant ces ouvertures, carctérisé en ce que:

des ouvertures constituant un second groupe et situées sur des régions de silicium de conductivité N (16) sont produites simultanément avec les ouvertures du premier groupe dans la couche de masquage (20, 21) et qu'elles sont recouvertes par une couche écran (24) avant le dépôt de la couche métallique, et

qu'après la formation du siliciure de métal la couche écran (24) est retirée des ouvertures du second groupe et qu'une couche de tantale (40) est alors déposée sur le siliciure de métal dans les ouvertures du premier groupe et dans les ouvertures du second groupe pour former des contacts à barrière de Schottky à seuil de potentiel faible.

2. Procédé selon la revendication 1, caractérisé en ce que le matériau utilisé est la platine.

**FIG. 1**

**FIG. 2**

**FIG. 3**

FIG. 4

FIG.5

FIG.6